# EUROPEAN PATENT SPECIFICATION

(11) **EP 1 919 023 B1**
(45) Date of publication and mention of the grant of the patent: **22.10.2014**
(21) Application number: 06780634.9
(22) Date of filing: 22.06.2006
(51) Int. Cl.: H01L 31/0224, H01L 31/04, H01M 14/00, H01G 9/20

(54) **ELECTRODE SUBSTRATE AND PHOTOELECTRIC CONVERTER**
ELEKTRODENSUBSTRAT UND FOTOELEKTRISCHER WANDLER
SUBSTRAT D ÉLECTRODE ET CONVERTISSEUR PHOTOÉLECTRIQUE

(30) Priority: 02.08.2005 JP 2005223920
(43) Date of publication of application: 07.05.2008
(73) Proprietor: FUJIKURA LTD., Koto-ku Tokyo 135-8512 (JP)
(72) Inventor: MATSUI, Hiroshi, c/o Fujikura Ltd., Tokyo 1358512 (JP); OKADA, Kenichi, c/o Fujikura Ltd., Tokyo 1358512 (JP); EZURE, Tetsuya, c/o Fujikura Ltd., Tokyo 1358512 (JP); TANABE, Nobuo, c/o Fujikura Ltd., Tokyo 1358512 (JP)
(74) Representative: Carter, Stephen John
(86) International application number: PCT/JP2006/312548
(87) International publication number: WO 2007/015342

(56) References cited:
- EP-A1- 1 548 868
- JP-A- 2000 285 974
- JP-A- 2004 164 970
- JP-A- 2005 078 857
- GEON-HO HWANG ET AL.: J. AM. CERAM. SOC., vol. 85, no. 12, 2002, pages 2956-2960, XP002670455,

## Description

### TECHNICAL FIELD

The present invention relates to an electrode substrate that is favorably used for such as a photoelectric conversion element such as a dye-sensitized solar cell, and specifically relates to an electrode substrate that has a current-collecting metal layer and a transparent conductive layer and is able to suppress degradation of the characteristics caused by leak current from the metal wiring to an electrolyte solution and corrosion of the current-collecting metal layer.

### BACKGROUND ART

Dye-sensitized solar cells, developed by the Swiss researcher Michael Graetzel et al., are a new type of solar cell attracting attention for their high photoelectric conversion efficiency and low manufacturing cost (for example, refer to Patent Document 1 and Non-Patent Document 1).

A dye-sensitized solar cell is provided with a working electrode having an oxide semiconductor porous film, by which a sensitizing dye consisting of oxide semiconductor fine particles is supported, on an electrode substrate, a counter electrode that is provided facing this working electrode, and a electrolyte layer that is formed by an electrolyte solution being filled between the working electrode and the counter electrode.

In this type of dye-sensitized solar cell, the oxide semiconductor fine particles are sensitized by a photosensitization dye that absorbs incident light such as sunlight, with an electromotive force being generated between the working electrode and a redox couple in the electrolyte. Thereby, the dye-sensitized solar cell functions as a photoelectric conversion element that converts light energy into electrical power (for example, refer to Patent Document 1 and Non-Patent Document 1, and the like).
Patent Document 1: Japanese Unexamined Patent Application, First Publication 10 No. H01-220380
Non-Patent Document 1: Graetzel, M. et al., Nature, United Kingdom, 1991, vol. 353, p. 737.

EP1,548,868A discloses an electrode substrate in which the surface of a metal circuit layer is covered and insulated by an insulating layer. In a photoelectric conversion element that uses this electrode substrate, the metal circuit layer is reliably shielded from an electrolyte solution or the like so that corrosion and leak current thereof is effectively prevented, and the photoelectric conversion efficiency can be improved. The insulating layer is preferably made of a material that contains a glass component, and is particularly preferably formed by printing a paste that contains glass frit. The metal circuit layer is preferably formed using a printing method.

Geon-Ho Hwang et al., J. Am. Ceram. Soc. Vol. 85, no. 12, 2002, pages 2956-2960 investigates the effects of chemical compositions on the sintering behaviour and physical properties of lead borosilicate glass developed for barrier ribs of plasma display panels. The formation of pores during sintering of the glass is noted and their formation mechanism investigated.

### DISCLOSURE OF INVENTION

### PROBLEM TO BE SOLVED BY THE INVENTION

A transparent electrode substrate that is used in the above-described dye-sensitized solar cell is generally made by covering a substrate surface with a transparent conductive film of tin-doped indium oxide (ITO) or fluorine-doped tin oxide (FTO) or the like. However, the specific resistance of ITO or FTO is of the order of 104 to 10·3 Ω·cm, a value approximately 100 times greater than the specific resistance of metals such as silver or gold and the like. Therefore, especially when used for large surface area cells, this can be a cause of a decline in the photoelectric conversion efficiency.

One technique of lowering the resistance of transparent electrode substrate is to increase the thickness of the transparent conductive film (such as the ITO or FTO). However, by forming the film to such a thickness that the resistance value is sufficiently lowered, the photoabsorption by a transparent conductive film increases. For that reason, since the transmission efficiency of incident light markedly falls, a reduction in the photoelectric conversion efficiency easily occurs.

As a solution to this problem, investigations are currently underway into lowering the resistance of the electrode substrate by providing metal wiring to an extent that does not markedly impair the aperture ratio on the surface of the transparent electrode substrate (for example, refer to Japanese Unexamined Patent Application, First Publication No. 2003-203681). In this case, in order to prevent corrosion of the metal wiring by the electrolyte solution and leak current from the metal wiring to the electrolyte solution, it is necessary for at least the surface portion of the metal wiring to be protected by some type of shielding layer. This shielding layer is required to be able to cover the circuit board densely and have excellent chemical resistance to the electrolyte solution and the like that constitutes the electrolyte layer. Materials that satisfy these requirements include insulating resin, glass and the like. However, due to cases of the substrate being subjected to a thermal history such as when forming the oxide semiconductor porous film, it is preferable to use glass, which has greater heat resistance than insulating resin.

However, a shielding layer that consists of glass can readily produce cracks due to volumetric changes associated with thermal processes when forming the shielding layer or after formation of the shielding layer. When cracks that occur in the shielding layer reach the metal wiring, there is the risk of the function of the cell being degraded by leak current from the metal wiring to the electrolyte solution and corrosion of the metal wiring by the electrolyte solution.

The present invention was achieved in view of the above circumstances, and has as its object to provide an electrode substrate that can lower the resistance of an electrode substrate and suppress degradation of the characteristics due to leak current from the metal wiring to an electrolyte solution and corrosion of the current-collecting metal layer, and a photoelectric conversion element that is appropriately used for a solar cell.

### MEANS FOR SOLVING THE PROBLEM

The method of manufacturing an electrode substrate in accordance with the present invention manufactures an electrode substrate comprising: a transparent conductive layer, a current-collecting metal layer that is provided on the transparent conductive layer, and an insulating layer that consists of glass frit and covers the current-collecting metal layer on a base plate, characterized in that, when a thermal expansion coefficient of the base plate is defined as α, and a thermal expansion coefficient of the insulating layer is defined as β, 0 ≤ α - β ≤ 17 × 10⁻⁷ is satisfied, and in that the method comprises: forming the transparent conductive layer and the current-collecting metal layer on the base plate; forming glass frit on an area where the current-collecting metal layer is formed, and baking the glass frit.

The electrode substrate in accordance with the present invention may be further characterized by the thickness of the transparent conductive layer being 0.05 to 5 µm.

The electrode substrate in accordance with the present invention may be further characterized by the base plate consisting of high strain point glass.

A photoelectric conversion element in accordance with the present invention is characterized by having any of the electrode substrates.

A dye-sensitized solar cell in accordance with the present invention is characterized by consisting of the photoelectric conversion element.

### EFFECTS OF THE INVENTION

In accordance with the electrode substrate of the present invention, it is possible to lower the resistance of the electrode substrate and possible to suppress degradation of the characteristics due to leak current from the metal wiring to the electrolyte solution and corrosion of the current-collecting metal layer.

### BRIEF DESCRIPTION OF THE DRAWINGS

FIG. 1 is a cross-sectional view showing a first example of the electrode substrate of the present invention.
FIG 2 is a partial plan view showing an example of the planar configuration of the current-collecting metal layer.
FIG 3 is a cross-sectional view showing a second example of the electrode substrate of the present invention.
FIG 4 is a cross-sectional view showing one embodiment of the photoelectric conversion element of the present invention.
FIG 5A is a cross-sectional view in the width direction of the current-collecting metal layer 12 showing an enlargement of a portion of the electrode substrate 1 in an Example 2 and an Example 3, while FIG 5B is a cross-sectional view in the width direction of the current-collecting metal layer 12 showing an enlargement of a portion of the electrode substrate 1 in an Example 5.

### BRIEF DESCRIPTION OF THE REFERENCE SYMBOLS

1 electrode substrate; 2 oxide semiconductor porous film; 3 working electrode; 4 counter electrode; 5 charge transfer layer; 6 photoelectric conversion element; 10 base plate; 11 transparent conductive layer; 12 current-collecting metal layer; 13 shielding layer; 14 insulating layer; 21 cracking; 31 corrosion

### BEST MODE FOR CARRYING OUT THE INVENTION

The preferred embodiment of the present invention shall be described below with reference to the drawings.

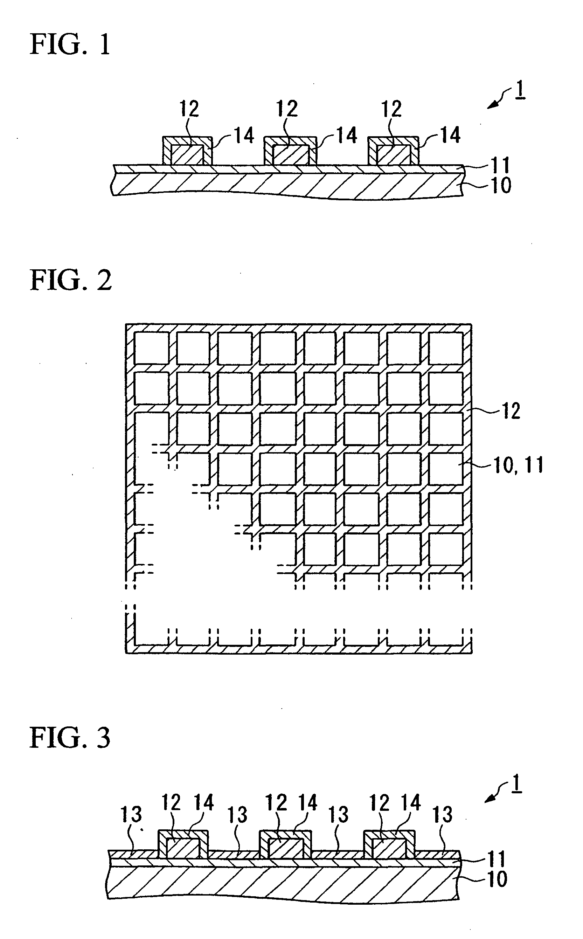

FIG. 1 is a cross-sectional view showing an example of an electrode substrate 1 of the present invention. The electrode substrate 1 shown in FIG 1 includes a transparent conductive layer 11, a current-collecting metal layer 12 that is formed on the transparent conductive layer 11, and an insulating layer 14 that covers the surface of the current-collecting metal layer 12 on a base plate 10, and when a thermal expansion coefficient of the base plate 10 is defined as α, and a thermal expansion coefficient of the insulating layer 14 is defined as β, α > β is satisfied.

The material of the base plate 10 is not particularly limited provided it is one with a coefficient of thermal expansion larger than the insulating layer 14 and having light transmittance. However, in terms of application the light transmittance is preferably as high as possible. As a specific example, it is possible to use borosilicate glass, soda lime glass, and high strain point glass. High strain point glass is preferred because deformation due to heat treatment is small, and its heat resistance is excellent. As borosilicate glass, it is possible for example to use one with a coefficient of thermal expansion of 72 × 10⁻⁷, as soda lime glass, it is possible for example to use one with a coefficient of thermal expansion of 86 × 10⁻⁷, and as high strain point glass it is possible for example to use one with a coefficient of thermal expansion of 85 × 10⁻⁷.

The transparent conductive layer 11 is formed on the base plate 10 over an area that is wider than the formation area of the current-collecting metal layer 12. The transparent conductive layer 11 can be made to be one layer or a plurality of layers. As the material of the transparent conductive layer 11, one with a coefficient of thermal expansion that is larger than the insulating layer 14 and smaller than the base plate 10 is preferred, and it is possible to make a selection in accordance with the application in consideration of light transmittance, conductivity, and the like.

Moreover, the thickness of the transparent conductive layer 11 is preferably in a range of 0.05 to 5 µm. When the thickness of the transparent conductive layer 11 is less than 0.05 µm, compared to the transparent conductive layer 11 with a thickness of 0.05 to 5 µm, the sheet resistance becomes large, leading to a possibility of causing a decline in the photoelectric conversion efficiency Also, when the thickness of the transparent conductive layer 11 exceeds 5 µm, light transmittance falls remarkably, causing a decline in photoelectric conversion efficiency.

Specifically, it is possible to make the transparent conductive layer 11 have one layer or a plurality of players consisting of a conductive metal oxide such as tin-doped indium oxide (ITO), indium oxide, tin oxide (SnO₂), or fluorine-doped tin oxide (FTO). The coefficient of thermal expansion of indium oxide is 72 × 10⁻⁷, and the coefficient of thermal expansion of SnO₂ is 35 × 10⁻⁷. Tin-doped indium oxide (ITO), compared to fluorine-doped tin oxide (FTO), has excellent light transmittance and conductivity but inferior heat resistance. Moreover, fluorine-doped tin oxide (FTO), compared to tin-doped indium oxide (ITO), has excellent heat resistance but inferior light transmittance and conductivity. In the case of using a composite film of fluorine-doped tin oxide (FTO) and tin-doped indium oxide (ITO) as the transparent conductive layer 11, an outstanding transparent conductive layer 11 is achieved in which the drawbacks of both are offset while retaining the advantages of both.

As a method of forming the transparent conductive layer 11, a publicly known appropriate method corresponding to the materials of the transparent conductive layer 11 may be used, including for example the sputtering method, evaporation method, SPD method, CVD method, or the like.

The current-collecting metal layer 12 is made of a metal such as gold, silver, platinum, aluminum, nickel, and titanium or the like and is formed into wire and electrically connected to the transparent conductive layer 11 and insulated by being covered with the insulating layer 14. The wiring pattern of the current-collecting metal layer 12 is not particularly limited, and may have a lattice pattern as shown in FIG 2, and in addition may have a pattern such as a stripe pattern, a band pattern, a comb pattern or the like.

In order to not markedly impair the light transmittance of the electrode substrate 1, the wiring width of each wire of the current-collecting metal layer 12 is preferably as thin as 1000 µm or less. Also, the thickness (height) of each wire of the current-collecting metal layer 12 is not particularly limited, however, it is preferably 0.1 to 50 µm.

Examples of the method used to form the current-collecting metal layer 12 include a method in which a paste is prepared by mixing metal particles that are to be conductive particles with a bonding agent such as fine glass particles, and coating this so as to form a predetermined pattern using a printing method such as a screen printing method, a metal mask method, or an inkjet method, and then heating and baking the substrate so as to make the conductive particles fuse. If the base plate 10 is, for example, glass, the baking temperature is preferably 600°C or lower, and more preferably 550°C or lower. In addition, a formation method such as a sputtering method, an evaporation method, and a plating method may be used.

The surface of the current-collecting metal layer 12 is preferably smooth, but it is more of a priority that it has high conductivity, and it is acceptable if a small amount of undulations or irregularities or the like are present.

The specific resistance of the current-collecting metal layer 12 is at least 9 × 10⁻⁵ Ω·cm or less, and more preferably 5 × 10⁻⁵ Ω·cm or less.

The insulating layer 14 consists of a glass frit layer of amorphous, crystalline, or complex system. The insulating layer 14 insulates and covers a current-collecting metal layer by being formed with one or a plurality of glass frit layers consisting of glass frit that includes lead oxide such as PbO-P₂O₅-SnF₂ or PbO-SiO₂-B₂O₃ or non-lead glass by a printing method on an area where the current-collecting metal layer 12 is formed. In the case of the insulating layer 14 consisting of a plurality of layers, the insulating layer 14 can be formed by two or more types of glass frit with different melt temperatures. Glass frit layer with a thermal expansion coefficient smaller than the base plate 10 is used as the material of the insulating layer 14. The glass frit layer with the thermal expansion coefficient being adjusted to approximately 65 × 10⁻⁷ to 69 × 10⁻⁷ can be used for example. Note that in the case of the insulating layer 14 consisting of a plurality of layers, the thermal expansion coefficient of the thickest layer is less than the base plate 10.

In accordance with the electrode substrate 1 of the present embodiment, since the current-collecting metal layer 12 is provided on the transparent conductive layer 11, it is possible to reduce the resistance of the electrode substrate 1. In accordance with the electrode substrate 1 of the present embodiment, when a thermal expansion coefficient of the base plate 10 is defined as α, and a thermal expansion coefficient of the insulating layer 14 is defined as β, α > β is satisfied, and the thickness of the transparent conductive layer 11 is 0.05 to 5 µm, cracking resulting from volumetric changes associated with thermal processes is hindered, and it is possible to suppress degradation of the characteristics by the leak current from the metal wiring to an electrolyte solution and corrosion of the current-collecting metal layer. Moreover, in the electrode substrate 1 of the present embodiment, since the insulating layer 14 is a glass frit layer, it can densely cover the current-collecting metal layer 12 and has excellent chemical resistance to the electrolyte solution and the like that constitutes the electrolyte layer.

Hereinbelow, modification examples of the electrode substrate of the present invention are described. In the electrode substrate of the modification examples below, reference numerals the same as those in FIG 1 denote the same or similar constitutions as the electrode substrate shown in FIG 1, and so overlapping explanations thereof shall be omitted here.

The electrode substrate shown in FIG 3 differs from the electrode substrate shown in FIG. 1 in terms of a shielding layer 13 being provided on the transparent conductive layer 11. The problems are minor compared with the current-collecting metal layer 12, but the leak current from the transparent conductive layer 11 has also been pointed out, so by providing the shielding layer 13 so as to cover the transparent conductive layer 11, it is possible to obtain a higher shielding effect.

As the material of the shielding layer 13, a compound is selected having a low electron transfer reaction speed with an electrolyte solution that includes a redox species and a high light transmittance state and transferability of photoelectrons, with oxide semiconductors such as titanium oxide (TiO₂), a zinc oxide (ZnO), niobium oxide (Nb₂O₅), and tin oxide (SnO₂) illustrated.

The shielding layer 13 must be formed thin enough not to prevent electronic transfer to the transparent conductive layer 11, and preferably has a thickness of about 1 to 1000 nm.

The method of forming the shielding layer 13 is not particularly limited, and examples thereof include a method of manufacturing an oxide semiconductor which is the desired compound or a precursor thereof by performing a dry method (i.e., gas phase method) such as a sputtering method, an evaporation method, or a CVD method. For example, when a film is being formed using a precursor of a metal or the like, by oxidizing the precursor using thermal treatment or chemical treatment, it is possible to obtain the shielding layer 13. If a wet method is used, after a solution that contains the desired compound or a precursor thereof has been coated using a method such as a spin coating method, a dipping method, or a blade coating method, the solution is chemically changed into the desired compound by thermal treatment or chemical treatment. Thus, the shielding layer 13 can be obtained. Examples of the precursor include salts and complexes having constituent metallic elements of the desired compound. In order to obtain a more dense film, a solution is more preferable than dispersion liquid. Other methods may be used to form the shielding layer 13 such as, for example, a spray thermal decomposition method in which the shielding layer 13 is formed by heating the base plate 10 having the transparent conductive layer 11, and spraying a substance for forming a precursor of the shielding layer 13 onto the base plate 10 so as to thermally decompose it and change it into the desired oxide semiconductor.

In this manner, because it is possible to suppress the leak current from the transparent conductive layer 11 by providing the shielding layer 13 that shields the transparent conductive layer 11, it is possible to manufacture a photoelectric conversion element having a higher photoelectric conversion efficiency.

Next, the photoelectric conversion element of the present invention shall be described.

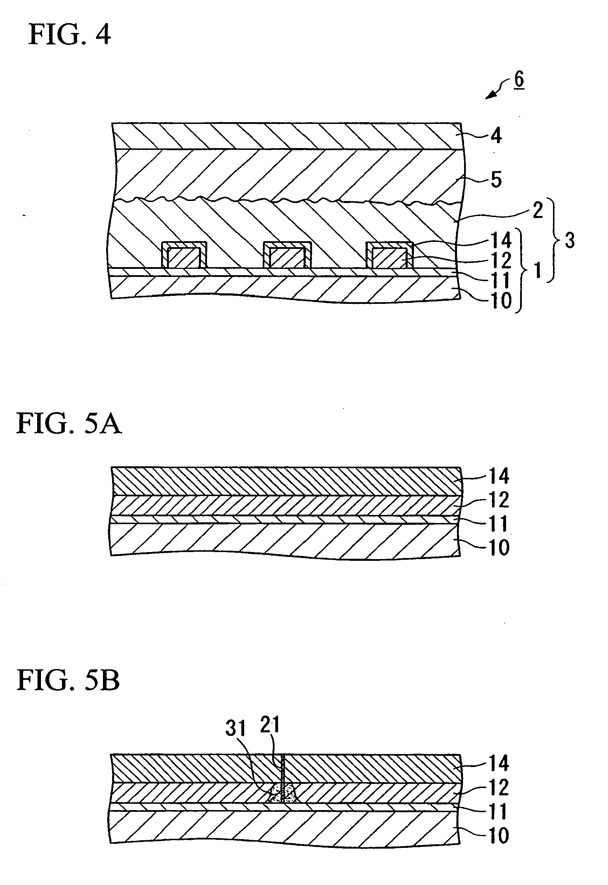

FIG. 4 shows an example of the photoelectric conversion element that constitutes a dye-sensitized solar cell. A photoelectric conversion element 6 is provided with a working electrode 3 having an oxide semiconductor porous film 2 on the electrode substrate 1 shown in FIG 1, and a counter electrode 4 that is provided facing the working electrode 3. Then, a charge transfer layer 5 that consists of an electrolyte or the like such as an electrolyte solution is formed between the working electrode 3 and the counter electrode 4. In the photoelectric conversion element 6 shown in FIG 4, the oxide semiconductor porous film 2, by which a photosensitization dye is supported, is formed on the surface of the electrode substrate 1, and the working electrode 3 of the photoelectric conversion element 6 is constituted by the electrode substrate 1 and the oxide semiconductor porous film 2.

Note that in FIG 4, the electrode substrate 1 shows the electrode substrate 1 of the constitution shown in FIG. 1; however, it is not particularly limited thereto.

The oxide semiconductor porous film 2 is a porous thin film consisting of oxide semiconductor fine particles made by one or combinations of titanium oxide (TiO₂), tin oxide (SnO₂), tungsten oxide (WO₃), zinc oxide (ZnO), and niobium oxide (Nb₂O₅). The average diameter of the oxide semiconductor fine particles is preferably in a range of 1 to 1000 nm. Also, the thickness of the oxide semiconductor porous film 2 is preferably 0.5 to 50 µm.

The oxide semiconductor porous film 2 can be formed not in a limited method, but for example, by employing methods such as a method in which a dispersion solution that is obtained by dispersing commercially available oxide semiconductor fine particles in a desired dispersion medium, or a colloid solution that can be adjusted using a sol-gel method is coated, after optionally desired additives have been added thereto, using a known coating method such as a screen printing method, an inkjet printing method, a roll coating method, a doctor blade method, a spin coating method, a spray coating method, or the like. Other methods include: an electrophoretic deposition method in which the electrode substrate 1 is immersed in a colloid solution and oxide semiconductor fine particles are made to adhere on the electrode substrate 1 by electrophoresis; a method in which a foaming agent is mixed in a colloid solution or a dispersion solution which is then coated and baked so as to form a porous material; and a method in which polymer microbeads are mixed together and coated, and these polymer microbeads are then removed by thermal treatment or chemical treatment, so as to define spaces and thereby form a porous material.

The sensitizing dye that is supported by the oxide semiconductor porous film 2 is not particularly limited. For example, a dye that provides excitation behavior that is appropriate to the application and the oxide semiconductor is used and can be selected from among ruthenium complexes and iron complexes having ligands that include bipyridine structures, terpyridine structures, and the like; metal complexes such as porphyrin systems and phthalocyanine systems; as well as organic dyes which are derivatives of eosin, rhodamine, melocyanine, and the like.

When the charge transfer layer 5 is made using an electrolyte, for example, an electrolyte solution that contains a redox pair may be used. It is also possible to use a gelled electrolyte obtained by quasi-solidifying the aforementioned electrolyte solution using an appropriate gelling agent such as a high-molecular gelling agent, a low-molecular gelling agent, various nano-particles, carbon nanotubes or the like. As the solvent for the electrolyte solution, it is possible to use an organic solvent or room temperature molten salt. Examples of the organic solvent include acetonitrile, methoxy acetonitrile, propionitrile, propylene carbonate, diethyl carbonate, and gamma-butyrolactone. Examples of the room temperature molten salt include salts made of imidazolium based cations or pyrrolidinium based cations, pyridinium based cations and iodide ions, bistrifluoromethyl sulfonylimido anions, dicyanoamide anions, thiocyanic acid anions, and the like.

The redox pair that is contained in the electrolyte is not particularly limited. For example, pairs such as iodine/iodide ions, bromine/bromide ions, and the like may be used. As a supply source of the iodide ions or the bromide ions, it is possible to use lithium salt, quaternized imidazolium salt, tetrabutylammonium salt singly or in combination. Additives such as 4-tert-butylpyridine (TBP) may be added as necessary to the electrolyte.

As the counter electrode 4, it is possible to use an electrode obtained by forming an electrode made up of one of various kinds of carbon based materials, a conductive polymer, a metal material such as gold or platinum, or a conductive oxide semiconductor such as ITO or FTO on a conductive substrate or a substrate made of an insulating material such as glass.

If the electrode is a platinum film, a method, such as applying and heat-treating chloroplatinic acid, can be illustrated. It is also possible to form an electrode by the evaporation method or sputtering method.

In accordance with the photoelectric conversion element 6 of the present embodiment, since the electrode substrate 1 has the current-collecting metal layer 12 that is electrically connected to the transparent conductive layer 11, it is possible to lower the resistance of the electrode substrate 1, and possible to substantially increase the cell characteristics. Moreover, in accordance with the electrode substrate 1 of the present embodiment, when the thermal expansion coefficient of the base plate 10 is defined as α, and the thermal expansion coefficient of the insulating layer 14 is defined as β, since α > β is satisfied, cracking resulting from volumetric changes associated with thermal processes is hindered, and the current-collecting metal layer 12 is securely shielded from the electrolyte solution of the charge transfer layer 5, and so it is possible to suppress degradation of the characteristics by the leak current from the metal wiring to an electrolyte solution and corrosion of the current-collecting metal layer.

### <Example 1>

The electrode substrate shown in FIG 1 was produced by the following procedure.

First, indium chloride (III) tetrahydrate and tin (II) chloride dihydrate are dissolved in ethanol to make the ITO film raw material solution. Also, a saturated water solution of ammonium fluoride was added and dissolved in an ethanol solution of tin (IV) pentahydrate to make the FTO film raw material solution.

Next, the base plate 10 made of soda-lime glass shown in 1 of Table 1 and measuring 100 mm × 100 mm with a thickness of 1.1 mm was placed on a heater plate and heated, the ITO film raw material solution was sprayed on the base plate 10 using a spray nozzle to form an ITO film with a film thickness of 700 nm, and then the FTO film raw material solution was sprayed on the base plate 10 using a spray nozzle to form an FTO film with a film thickness of 100 nm, whereby the transparent conductive layer 11 with a film thickness of 800 nm was formed consisting of the composite FTO and ITO films.

**[Table 1]**

| | | Coefficient of Thermal Expansion (× 10⁻⁷) | Strain Point |
|---|---|---|---|
| 1 | Soda-lime Glass | 86 | 510 |
| 2 | High Strain Point Glass | 85 | 583 |
| 3 | High Strain Point Glass | 83 | 570 |
| 4 | Heat Resistant Glass (TEMPAX) | 32 | 570 |
| 5 | Borosilicate Glass (with alkali) | 72 | 529 |
| 6 | Glass frit | 69 | - |
| 7 | Glass frit | 69 | - |

Next, silver paste for printing (with a volume resistivity after sintering of 3 × 10⁻⁶ Ω) was screen printed on the FTO film. After 10 minutes of leveling, the paste was dried in a hot air circulating furnace at 135°C for 20 minutes, and was then baked for 15 minutes at 550°C to form the current-collecting metal layer 12 having a silver circuit.

Here, the circuit width of the current-collecting metal layer 12 is 300 µm, and the film thickness is 5 µm, forming a shape that extends in a strip shape from a collecting terminal. Then, glass frit shown in 7 of Table 1 was printed by overlapping with the current-collecting metal layer 12 by screen printing while alignment was conducted with a CCD camera and then baked to form the insulating layer 14. The electrode substrate of Example 1 was thus obtained.

Note that the formation width of the insulating layer 14 is 500 µm with an excess of 100 µm per one side of the current-collecting metal layer 12 on both sides of the width direction of the current-collecting metal layer 12.

### <Example 2 to Example 8>

Next, on the base plate 10 made of any of the materials shown in 2 to 4 of Table 1 measuring 100 mm × 100 mm with a thickness of 2.8 mm, the transparent conductive layer 11 with a film thickness of 800 nm consisting of the composite of FTO and ITO films and the current-collecting metal layer 12 are formed similarly to Example 1. Then, similarly to Example 1, the material shown in 6 or 7 of Table 1 is printed and baked, whereby the insulating layer 14 is formed, and the electrode substrates of Example 2 to Example 8 are obtained.

Table 1 shows the thermal expansion coefficients of the materials used in Example 1 to Example 8. Also, Table 2 shows combinations of the material of the base plate 10 and the material of the insulating layer 14 in Example 1 to Example 8.

Note that Example 1 to Example 6 of Table 1 and Table 2 are embodiments of the present invention satisfying the condition α > β in which α is the thermal expansion coefficient of the base plate 10 and β is the thermal expansion coefficient of the insulating layer 14, and Example 7 and Example 8 are comparative examples that do not satisfy the condition α > β.

**Table 2**

| Example | Base plate | Insulating Layer | Cracking |
|---|---|---|---|
| 1 | 1 | 7 | None |
| 2 | 1 | 6 | None |
| 3 | 2 | 7 | None |
| 4 | 2 | 6 | None |
| 5 | 5 | 7 | None |
| 6 | 5 | 6 | None |
| 7 | 4 | 7 | Present |
| 8 | 4 | 6 | Present |

The surface of the electrode substrate of Example 1 to Example 8 obtained in this way was visually observed using an optical microscope. As a result, as shown in FIG 2, a fine surface was formed with no cracking on the surface in Example 1 to Example 4, which are embodiments of the present invention. In contrast, in Example 7 and Example 8 which are comparative examples as shown in Table 2, cracking occurred on the surface of the insulating layer 14.

### <Example 9>

The transparent conductive layer 11 similar to Example 1 was formed on the same base plate 10 as Example 1, and the electrode substrate of Example 9 was obtained.

The electrode substrates of Example 2, Example 3, Example 7 and Example 9 obtained in this way are overlapped with the glass substrate on which an electrode consisting of a platinum layer and an FTO film is formed on the surface, with the current-collecting metal layer 12 of the electrode substrate and the electrode of the glass substrate facing each other in the state of an insulating resin sheet with a thickness of 50 µm being interposed as a spacer. Next, by dissolving 0.5 (mol/1) 1, 3-dialkyl imidazolium iodide salt and 0.05 (mol/l) iodine in methoxyacetonitrile between the electrode substrate and the glass substrate, and filling up an iodine electrolyte solution to which 0.1 (mol/1) lithium iodide (LiI) and 0.5 (mol/1) 4-tert-butylpyridine (TBP) are added, an immersion test was performed that involves immersing the side surface of the current-collecting metal layer 12 of the electrode substrate in the iodine electrolyte solution for 5 to 10 minutes, and the presence of discoloring of an iodine electrolyte solution and the presence of leakage current during the immersion test were investigated.

As a result, in Example 7 which is a comparative example, it is apparent that the iodine electrolyte solution immediately discolors and the iodine electrolyte solution that intrudes from cracks in the insulating layer 14 reacts with the silver that constitutes the current-collecting metal layer 12. In contrast, in Example 2 and Example 3 that are embodiments of the present invention, no discoloring of the iodine electrolyte solution is observed, and so it is apparent that the iodine electrolyte solution has not reacted with the current-collecting metal layer 12.

Also, the leakage current density of Example 7 was 1 × 10⁻⁴ A/cm², with leakage current being thus observed. In contrast, the leakage current density of Example 2 and Embodiment 3 was 1 × 10⁻⁸ A/cm², which is the limit-of-measurement level, similarly to Example 9 without the current-collecting metal layer 12.

Also, after the immersion test, the cross section in the width direction of the current-collecting metal layer 12 in the electrode substrate of Example 2, Example 3, and Example 7 was observed using a scanning electron microscope (SEM). The result shall be explained with reference to FIG 5. FIG 5A is a cross-sectional view in the width direction of the current-collecting metal layer 12 shown by enlarging a portion of the electrode substrate 1 of Example 2 and Example 3. FIG 5B is a cross-sectional view in the width direction of the current-collecting metal layer 12 shown by enlarging a portion of the electrode substrate 1 of Example 7.

In Example 2 and Example 3 that are embodiments of the present invention, no cracking occurred that reaches the current-collecting metal layer 12 as shown in FIG 5A. In contrast, in Example 7 that is a comparative example, a crack 21 occurred reaching the current-collecting metal layer 12 shown in FIG 5B at some places on the insulating layer 14, and corrosion 31 of the current-collecting metal layer 12 occurred by the iodine electrolyte solution that invaded from the crack 21. Thereby, when the thermal expansion coefficient of the base plate 10 is α, and the thermal expansion coefficient of the insulating layer 14 is β, by satisfying the condition α > β, it was possible to confirm that it is possible to suppress cracking.

Also, using the electrode substrate of Example 2, Example 3, Example 7, and Example 9, an immersion test was performed similarly to above except for performing immersion for 30 to 60 minutes using as the iodine electrolyte solution one made by dissolving iodine in 1-hexyl 3-methyl imidazolium iodide at a composition ratio (molar ratio) of 10:1, and the presence of discoloring of the iodine electrolyte solution and the presence of leakage current were investigated.

As a result, in Example 7 that is a comparative example, it is apparent that the color of the iodine electrolyte solution immediately discolors and the iodine electrolyte solution that intrudes from cracks in the insulating layer 14 reacts with the silver that constitutes the current-collecting metal layer 12. In contrast, in Example 2 and Example 3 that are embodiments of the present invention, no discoloring of the iodine electrolyte solution is observed, and so it is apparent that the iodine electrolyte solution does not react with the current-collecting metal layer 12.

Also, leakage current was observed in Example 7, but the leakage current of Example 2 and Embodiment 3 was at or below the limit-of measurement level, similarly to Example 9 without the current-collecting metal layer 12.

Next, the photoelectric conversion element shown in FIG. 4 was manufactured by the following procedure.

First, a titanium oxide dispersion solution with an average particle diameter of 13 to 20 nm was coated on the electrode substrate of Example 1 to Example 9. It was then dried, heat treated, and baked for one hour at 450° C. As a result, the oxide semiconductor porous film 2 was formed. It was further immersed overnight in an ethanol solution of a ruthenium bipyridine complex (an N3 dye) so as to be sensitized with a dye. As a result, the working electrode 3 was prepared. For the counter electrode 4, a platinum sputtered FTO glass electrode substrate was used. This counter electrode 4 and the working electrode 3 were positioned facing each other with a 50 µm thick thermoplastic resin sheet interposed between the two as a spacer. The two electrodes 3 and 4 were then secured by heat-melting the resin sheet. At this time, a portion of a side of the counter electrode 4 was left open in order to define an electrolyte injection aperture. An iodine electrolyte solution was then injected via the solution injection aperture so as to form the charge transfer layer 5. Next, peripheral portions and the solution injection aperture were fully sealed by a thermoplastic resin sheet and an epoxy based sealing resin, and collecting terminal portions were formed using glass solder so as to prepare a photoelectric conversion element for use as a test cell. The test cell was evaluated using 100 mW/cm² pseudo sunlight having an AM of 1.5.

As a result, it was found that the conversion efficiency of Example 1, which is an embodiment of the present invention, was 3.1%, the conversion efficiency of Example 2 was 4.8%, the conversion efficiency of Example 3 was 4.8%, the conversion efficiency of Example 4 was 5.0%, the conversion efficiency of Example 5 was 4.5%, and the conversion efficiency of Example 6 was 4.6%, thus exhibiting good output characteristics.

In contrast, the conversion efficiency of Example 7 and Example 8, which are comparative examples, was 2.2% and 1.6%, respectively, indicating that corrosion of the current-collecting metal layer 12 by the iodine electrolyte solution that intruded from cracks occurred, with good output characteristics thus not being obtained.

Also, the conversion efficiency of Example 9 without the current-collecting metal layer 12 was 1.9%, and due to the internal resistance being great, the output significantly deteriorated compared to Example 1 to Example 6 which are embodiments of the present invention.

### <EXAMPLE 9 TO EXAMPLE 12, EXAMPLE 15 TO EXAMPLE 25, EXAMPLE 28 TO EXAMPLE 31>

The electrode substrate shown in FIG 1 was manufactured by the following procedure.

First, an ITO film raw material solution similar to Example 1 was prepared. Next, the 100 mm × 100 mm base plate 10 consisting of any material of 1, 3, 4, 5 of Table 1 was placed on a heat plate and heated. The ITO film raw material solution was sprayed on the base plate 10 using a spray nozzle to form an ITO film with a film thickness shown in Table 3 to form the transparent conductive layer 11.

Next, similarly to Example 1, the current-collecting metal layer 12 consisting of a silver circuit and the insulating layer 14 of a material shown in 5 of Table 1 are formed on the transparent conductive layer 11, and the electrode substrates of Example 9 to Example 12, Example 15 to Example 25, and Example 28 to Example 31 shown in FIG 3 to FIG 6 are obtained.

**Table 3**

| Example | Base plate | Base plate Thickness (mm) | Insulating Layer | Transparent Conductive Layer | Transparent Conductive Layer Thickness (µm) | Cracking |
|---|---|---|---|---|---|---|
| 9 | 1 | 1.1 | 5 | ITO | 0.05 | None |
| 10 | | | | | 1 | None |
| 11 | | | | | 2 | None |
| 12 | | | | | 5 | None |
| 13 | | | | FTO | 1 | None |
| 14 | | | | FTO/ITO | 1 | None |

**Table 4**

| Example | Base plate | Base plate Thickness (mm) | Insulating Layer | Transparent Conductive Layer | Transparent Conductive Layer Thickness (µm) | Cracking | Sheet Resistance | Light Transmittance |
|---|---|---|---|---|---|---|---|---|
| 15 | 3 | 2.8 | 5 | ITO | 0.025 | None | × | ○ |
| 16 | | | | | 0.05 | None | Δ | ○ |
| 17 | | | | | 0.2 | None | ○ | ○ |
| 18 | | | | | 0.7 | None | ○ | ○ |
| 19 | | | | | 2 | None | ○ | ○ |
| 20 | | | | | 5 | None | ○ | Δ |
| 21 | | | | | 6 | None | ○ | × |

**Table 5**

| Example | Base plate | Base plate Thickness (mm) | Insulating Layer | Transparent Conductive Layer | Transparent Conductive Layer Thickness (µm) | Cracking |
|---|---|---|---|---|---|---|
| 22 | 5 | 0.2 | 5 | ITO | 0.05 | None |
| 23 | | | | | 1 | None |
| 24 | | | | | 2 | None |
| 25 | | | | | 5 | None |
| 26 | | | | FTO | 1 | None |
| 27 | | | | FTO/ITO | 1 | None |

**Table 6**

| Example | Base plate | Base plate Thickness (mm) | Insulating Layer | Transparent Conductive Layer | Transparent Conductive Layer Thickness (µm) | Cracking |
|---|---|---|---|---|---|---|
| 28 | 4 | 2.8 | 5 | ITO | 0.05 | Present |
| 29 | | | | | 1 | Present |
| 30 | | | | | 2 | Present |
| 31 | | | | | 5 | Present |
| 32 | | | | FTO | 1 | Present |
| 33 | | | | FTO/ITO | 1 | Present |

### <EXAMPLE 13, EXAMPLE 26, EXAMPLE 32>

The electrode substrate shown in FIG 1 was produced by the following procedure.

First, an FTO film raw material solution similar to Example 1 was prepared. Next, 100 mm × 100 mm base plate 10 consisting of any material of 1, 4, 5 of Table 1 was placed on a heat plate and heated. The FTO film raw material solution was sprayed on the base plate 10 using a spray nozzle to form an ITO film with a film thickness shown in Table 3 to form the transparent conductive layer 11.

Next, similarly to Example 1, the current-collecting metal layer 12 consisting of a silver circuit and the insulating layer 14 of a material shown in 5 of Table 1 are formed on the transparent conductive layer 11, and the electrode substrates of Example 13, Example 26 and Example 32 shown in Table 3, Table 5 and Table 6, respectively, are obtained.

### <EXAMPLE 14, EXAMPLE 27, EXAMPLE 33>

The electrode substrate shown in FIG 1 was produced by the following procedure.

First, an ITO film raw material solution and an FTO film raw material solution similar to Example 1 were prepared. Next, the 100 mm × 100 mm base plate 10 consisting of any material of 1, 4, 5 of Table 1 was placed on a heat plate and heated. The ITO film raw material solution was sprayed on the base plate 10 using a spray nozzle to form an ITO film with a film thickness of 0.8 µm, and then the FTO film raw material solution was sprayed on the base plate 10 using a spray nozzle to form an FTO film with a film thickness of 0.2 µm to form an FTO/ITO composite film with a thickness of 1 µm as the transparent conductive layer 11.

Next, similarly to Example 1, the current-collecting metal layer 12 consisting of a silver circuit and the insulating layer 14 of a material shown in 5 of Table 1 are formed on the transparent conductive layer 11, and the electrode substrates of Example 14, Example 27, Example 33 in Table 3, Table 5 and Table 6, respectively, are obtained.

The thermal expansion coefficient of the material used in Example 9 to Example 33 is shown in Table 1. Also, Table 3 to Table 6 show combinations of the material of the base plate 10 and the material of the insulating layer 14 in Example 9 to Example 33.

Note that Example 9 to Example 14, Example 16 to Example 20, Example 22 to Example 27 of Table 1 and Table 3 to Table 6 are embodiments of the present invention that satisfy the condition α > β when the thermal expansion coefficient of the base plate 10 is α, and the thermal expansion coefficient of the insulating layer 14 is β, and Example 29 to Example 34 are comparative examples that do not satisfy α > β Example 15 is a comparative example in which the thickness of the transparent conductive layer 11 is less than 0.05 µm, and Example 21 is a comparative example in which the thickness of the transparent conductive layer 11 exceeds 5 µm.

The surface of the electrode substrate of Example 9 to Example 33 obtained in this way was visually observed using an optical microscope. As a result, as shown in Table 3 to Table 5, a dense surface was formed with no cracking on the surface in Example 9 to Example 14, Example 16 to Example 20, Example 22 to Example 27, which are embodiments of the present invention. In contrast, in Example 28 to Example 33 which are comparative examples that do not satisfy the condition α > β as shown in Table 6, cracking occurred on the surface of the insulating layer 14.

Also, the sheet resistance of Example 15 to Example 21 was investigated, with the following determinations made.
○ : A value less than 5 assuming the sheet resistance is 1 when the thickness of the transparent conductive layer is 0.7 µm.
Δ: A value in a range of 5 to 1000 assuming the sheet resistance is 1 when the thickness of the transparent conductive layer is 0.7 µm.
×: A value exceeding 1000 assuming the sheet resistance is 1 when the thickness of the transparent conductive layer is 0.7 µm.

The result in shown in Table 4.

Also, the light transmittance of Example 15 to Example 21 was investigated, with the following determinations made.
○ : A value exceeding 0.9 assuming the light transmittance is 1 when the thickness of the transparent conductive layer is 0.7 µm.
Δ : A value in a range of 0.6 to 0.9 assuming the light transmittance is 1 when the thickness of the transparent conductive layer is 0.7 µm.
×: A value less than 0.6 assuming the light transmittance is 1 when the thickness of the transparent conductive layer is 0.7 µm.

The result is shown in Table 4.

From Table 4, the following points are evident.
(1) When the thickness of the transparent conductive layer is 0.025 to 6 µm, there is no cracking on the surface.
(2) The sheet resistance becomes a value of 1000 or less when 1 is set as a value when the thickness of the transparent conductive layer is greater than or equal to 0.05 µm and the thickness of the transparent conductive layer is 0.7 µm, and when the thickness of the transparent conductive layer is 0.2 µm or more, a tendency of becoming a value of 5 or less is recognized with a value of 1 for when the thickness of the transparent conductive layer is 0.7 µm.
(3) The light transmittance becomes a value exceeding 0.6 when 1 is set as a value when the thickness of the transparent conductive layer is 0.7 µm, and when the thickness of the transparent conductive layer is 2 µm or less, a tendency of becoming a value exceeding 0.9 is recognized with a value of 1 for when the thickness of the transparent conductive layer is 0.7 µm.

Therefore, when the thickness of the transparent conductive layer is in a range of 0.05 to 5 µm, there are no cracks on the surface, and it is preferable that the light transmittance is a value exceeding 0.6 when 1 is set as a value when the thickness of the transparent conductive layer is 0.7 µm, and the sheet resistance is a value of 1,000 or less when 1 is set as a value when the thickness of the transparent conductive layer is 0.7 µm. Moreover, if the thickness of the transparent conductive layer is in a range of 0.2 to 2 µm, it could be confirmed that it is more preferable that the light transmittance is a value exceeding 0.9 when 1 is set as a value when the thickness of the transparent conductive layer is 0.7 µm, and the sheet resistance is a value of 5 or less when 1 is set as a value when the thickness of the transparent conductive layer is 0.7 µm.

### INDUSTRIAL APPLICABILITY

In accordance with the present invention, it is possible to provide an electrode substrate and a photoelectric conversion element that is suitably used in a solar battery that can lower the resistance of an electrode substrate, and moreover suppress degradation of the characteristics due to leak current from the metal wiring to the electrolyte solution and corrosion of the current-collecting metal layer.

## Claims

1. A method of manufacturing an electrode substrate, the electrode substrate (1) comprising:
a transparent conductive layer (11),
a current-collecting metal layer (12) that is provided on the transparent conductive layer (11), and
an insulating layer (14) that consists of glass frit and covers the current-collecting metal layer (12) on a base plate (10);
**characterized in that**, when a thermal expansion coefficient of the base plate (10) is defined as α, and a thermal expansion coefficient of the insulating layer (14) is defined as β, 0 ≤ α - β ≤ 17 × 10⁻⁷ is satisfied, and **in that** the method comprises:
forming the transparent conductive layer (11) and the current-collecting metal layer (12) on the base plate (10);
forming glass frit on an area where the current-collecting metal layer (12) is formed, and
baking the glass frit.

2. The method accordance with claim 1, wherein the thickness of the transparent conductive layer (11) is in a range of 0.05 to 5 µm.

3. The method in accordance with claim 1 or claim 2, wherein the base plate (10) consists of high strain point glass.

4. A photoelectric conversion element (6) that has an electrode substrate (1) obtained in accordance with the method of any one of claim 1 to claim 3.

5. A dye-sensitized solar cell that consists of the photoelectric conversion element (6) in accordance with claim 4.

## Patentansprüche

1. Verfahren zur Herstellung eines Elektrodensubstrats, wobei das Elektrodensubstrat (1) Folgendes umfasst:
eine transparente leitfähige Schicht (11),
eine Stromsammelmetallschicht (12), die auf der transparenten leitfähigen Schicht (11) bereitgestellt ist, und
eine Isolierschicht (14), die aus Glasfritte besteht und die Stromsammelmetallschicht (12) auf einer Basisplatte (10) abdeckt;
**dadurch gekennzeichnet, dass** wenn ein Wärmeausdehnungskoeffizient der Basisplatte (10) als α definiert ist, und ein Wärmeausdehnungskoeffizient der Isolierschicht (14) als β definiert ist, 0 ≤ α - β ≤ 17 x 10⁻⁷ erfüllt ist, und dass das Verfahren Folgendes umfasst:
Ausbilden der transparenten leitfähigen Schicht (11) und der Stromsammelmetallschicht (12) auf der Basisplatte (10);
Ausbilden der Glasfritte auf einem Bereich, in dem die Stromsammelmetallschicht (12) ausgebildet ist, und
Brennen der Glasfritte.

2. Verfahren nach Anspruch 1, wobei die Dicke der transparenten leitfähigen Schicht (11) im Bereich von 0,05 bis 5 µm liegt.

3. Verfahren nach Anspruch 1 oder 2, wobei die Basisplatte (10) aus Glas mit einem hohen unteren Kühlpunkt besteht.

4. Photoelektrisches Umwandlungselement (6), das ein Elektrodensubstrat (1) aufweist, das entsprechend dem Verfahren nach einem der Ansprüche 1 bis 3 erhalten wird.

5. Farbstoffsolarzelle, die aus dem photoelektrischen Umwandlungselement (6) nach Anspruch 4 besteht.

## Revendications

1. Procédé de fabrication d'un substrat d'électrode, le substrat d'électrode (1) comprenant :
une couche conductrice transparente (11),
une couche métallique de collecte de courant (12) qui est prévue sur la couche conductrice transparente (11), et
une couche isolante (14) qui consiste en une poudre de verre et qui recouvre la couche métallique de collecte de courant (12) sur une plaque de base (10) ;
**caractérisé en ce que**, lorsqu'un coefficient de dilatation thermique de la plaque de base (10) est défini par α, et qu'un coefficient de dilatation thermique de la couche isolante (14) est défini par β, 0 ≤ α - β ≤ 17 x 10⁻⁷ est satisfait, et **en ce que** le procédé comprend :
la formation de la couche conductrice transparente (11) et de la couche métallique de collecte de courant (12) sur la plaque de base (10) ;
la formation de la poudre de verre dans une zone dans laquelle la couche métallique de collecte de courant (12) est formée ; et
la cuisson de la poudre de verre.

2. Procédé selon la revendication 1, dans lequel l'épaisseur de la couche conductrice transparente (11) est dans une plage de 0,05 à 5 mm.

3. Procédé selon la revendication 1 ou la revendication 2, dans lequel la plaque de base (10) consiste en du verre à point de trempe élevé.

4. Elément de conversion photoélectrique (6) qui comporte un substrat d'électrode (1) obtenu selon le procédé de l'une quelconque de la revendication 1 à la revendication 3.

5. Cellule solaire sensibilisée par colorant qui consiste en l'élément de conversion photoélectrique (6) selon la revendication 4.
